# EUROPÄISCHE PATENTSCHRIFT

(11) **EP 3 257 238 B1**
(45) Veröffentlichungstag und Bekanntmachung des Hinweises auf die Patenterteilung: **28.08.2019**
(21) Anmeldenummer: 16700959.6
(22) Anmeldetag: 15.01.2016
(51) Int. Cl.: H04N 5/225, H01L 31/0203

(54) **BILDAUFNAHMESYSTEM UND EIN KRAFTFAHRZEUG**
IMAGE RECORDING SYSTEM AND A MOTOR VEHICLE
SYSTÈME DE PRISE DE VUES ET VÉHICULE AUTOMOBILE

(30) Priorität: 10.02.2015 DE 102015202314; 20.07.2015 DE 102015213575
(43) Veröffentlichungstag der Anmeldung: 20.12.2017
(73) Patentinhaber: Robert Bosch GmbH, 70442 Stuttgart (DE)
(72) Erfinder: GEISE, Stephan, 59602 Ruethen (DE); APELT, Stefan, 71554 Weissach Im Tal (DE)
(86) Internationale Anmeldenummer: PCT/EP2016/050797
(87) Internationale Veröffentlichungsnummer: WO 2016/128173

(56) Entgegenhaltungen:
- WO-A1-00/38249
- WO-A1-2014/075462
- JP-A- 2002 258 129
- US-A1- 2001 050 717
- US-A1- 2004 080 642
- US-A1- 2004 251 509

## Beschreibung

Die vorliegende Erfindung betrifft ein Bildaufnahmesystem und ein Kraftfahrzeug.

### Stand der Technik

Bildaufnahmesysteme finden in vielen Bereichen Anwendung. Ein Beispiel ist die Anwendung in Kraftfahrzeugen. Optische Kamerasysteme (Bildaufnahmesysteme) in Kraftfahrzeugen erfassen beispielsweise das Fahrzeugumfeld und liefern Informationen für weitere Fahrzeugsysteme. Bildaufnahmesysteme werden beispielsweise für Nachtsichtanwendungen (Night Vision), zur Spurhalteüberwachung (lane-departure warning) und zur Überwachung des Front- oder Heckbereichs des Fahrzeugs verwendet.

Bildaufnahmesysteme umfassen dabei einen Optikhalter, einen Optikträger (Objektiv) mit mehreren Linsen sowie einen Bildaufnehmer auf einer Trägerplatte (Imager-Chip).

Der Optikhalter und der Optikträger werden unabhängig voneinander hergestellt, Die aufwendigen Objektive haben oft speziell geschliffene Linsen.

Bei der Montage des Kamerasystems ist darauf zu achten, dass der Optikträger inklusive Optik zum Bildaufnehmer optisch ausgerichtet ist, da nur dann gewährleistet ist, dass der Bildaufnehmer das richtige Bild erfasst.

Aus der DE 102006008230 A1 ist beispielsweise ein Bildaufnahmesystem, insbesondere für Automotive-Anwendungen, bekannt mit einem Substrat, einem Bildsensor, der auf dem Substrat befestigt ist, einer vor dem Bildsensor angeordnete Optikeinheit und einen mit dem Substrat verbundenen Optikhalter, in dem die Optikeinheit aufgenommen ist.

Ein Kamerasystem mit Justagemöglichkeit, bei der der Optikträger gegenüber dem Bildaufnehmer ausgerichtet werden kann, wird in EP 1 716 018 B1 beschrieben. In EP 2054270 B1 wird im Wesentlichen ein Montagesystem von einem Kamerasystem beschrieben. US 2004/251509 A1 ist mit einem Bildsensormodul vom CMOS-Typ mit einer transparenten Verkapselung befasst. JP 2002 258129 A betrifft ein vibrationssicheres Linsensystem.

### Offenbarung der Erfindung

Erfindungsgemäß werden ein Bildaufnahmesystem gemäß Anspruch 1 und ein Kraftfahrzeug gemäß Anspruch 9 zur Verfügung gestellt.

Das Bildaufnahmesystem umfasst zumindest einen Optikhalter mit einem Durchgangsloch, eine das Durchgangsloch auf einer Seite mit einer Oberfläche verschließenden Trägerplatte und einen Bildaufnehmer, der auf der Oberfläche der Trägerplatte angeordnet ist. Das Bildaufnahmesystem ist gekennzeichnet durch einen bis vom Durchgangsloch zu einer Außenseite des Optikhalters durch den Optikhalter durchgehenden Nadelkanal, wobei der Nadelkanal zum Spritzgießen einer als optische Linse wirkenden Verkapselung des Bildaufnehmers geeignet ist.

Der Nadelkanal erlaubt die als Linse wirkende Verkapselung durch Spritzgießen herzustellen nachdem der Optikhalter hergestellt wurde. Dies wiederum ermöglicht, die als Linse wirkende Verkapselung herzustellen, ohne eine Oberfläche der Verkapselung während der Herstellung des Optikhalters schützen zu müssen. Insbesondere wird eine Fertigung einer mikrostrukturierten Schutzlinse direkt nach Fertigung des Optikhalters auf einem selben Spritzgießwerkzeug ermöglicht. Dank der sehr guten Abformeigenschaften des duroplastischen Materials ist die als Linse wirkende Verkapselung einfach herstellbar. Insgesamt bewirken die Merkmale der Erfindung, dass ein mit wenigen Prozessschritten und vereinfachter Logistik kostengünstig und gegen Umwelteinflüsse robustes Kamerasystem herstellbar wird, welches im Aufbau einfach und platzsparend ist.

Die Verwendung von transparentem duroplastischen Material für eine Verkapselung bringt weiterhin viele Vorteile: Die Fertigung etwa lässt sich komplett auf einer Spritzgießmaschine mit nur einem Spritzgießwerkzeug realisieren. Weiterhin kann die temperaturabhängige Änderung des Brechungsindex des duroplastischen Materials verwendet werden, um einen thermischen Fokusshift eines Objektivs zu kompensieren. Zudem ist duroplastisches Material sehr beständig gegenüber Umwelteinflüssen wie beispielsweise ultraviolettes Licht (UV-Licht).

In einer Ausführungsform umfasst das Bildaufnahmesystem weiterhin die formstabile, als optische Linse wirkenden Verkapselung des Bildaufnehmers, wobei die Verkapselung mindestens ein transparentes duroplastisches Material umfasst, wobei sich das duroplastische Material durch den Nadelkanal bis zu der Außenseite erstreckt.

Die Trägerplatte kann weiterhin mit einer Schaltung bestückt sein, die auch von der Verkapselung umschlossen ist. Dann ist auch die Schaltung vor Umwelteinflüssen geschützt.

Die Trägerplatte kann mindestens eine Bonddraht-Schaltung umfassen.

Dank der günstigen Eigenschaften des duroplastischen Materials beim Versiegeln können Bonddraht-Schaltungen mitversiegelt werden, ohne dass Schäden an den Bonddraht-Schaltungen zu befürchten wären.

Das duroplastische Material kann Silikon, Polyurethan und/oder Epoxid umfassen.

Die Verkapselung kann eine Oberflächenstruktur aufweisen, die entspiegelnd wirkt. Eine entspiegelnde Oberflächenstruktur ist dank der sehr guten Abformeigenschaften des duroplastischen Materials einfach herstellbar.

Der Nadelkanal kann sich parallel zu der Oberfläche der Trägerplatte erstrecken.

Der Optikhalter kann ein weiteres duroplastisches Material umfassen, welches ein Phenolformaldehyd Compound, ein Epoxid und/oder ein Bulk Moulding Compound umfasst, dass zu 50 bis 70% mit wärmeleitfähigen Partikeln versetzt ist. Die wärmeleitfähigen Partikel können Bornitrid, Aluminiumhydroxid und/oder Magnesiumhydroxid umfassen. Ein Faseranteil des weiteren duroplastischen Materials kann zu 10 bis 30% von Metallfasern gebildet werden. Die Metallfasern können Kuper, Aluminium und/oder Silber umfassen. Die Metallfasern können ein Gewebe sein.

Mittels der wärmeleitfähigen Partikel können Trägerplatte und Bildaufnehmer erwärmt werden. Die Metallfasern verleihen, insbesondere aber nicht nur in Gewebeform, dem Optikhalter die erforderliche Festigkeit. Zusätzlich oder alternativ bieten sie Schutz gegen elektromagnetische Strahlung.

Das Bildaufnahmesystem kann weiterhin ein Objektiv bildende Linsen umfassen, die vom Optikhalter an Haltepositionen gehalten werden.

Das erfindungsgemäß vorgestellte Kraftfahrzeug umfasst das erfindungsgemäß vorgestellte Bildaufnahmesystem.

Vorteilhafte Weiterbildungen der Erfindung sind in den Unteransprüchen angegeben und in der Beschreibung beschrieben.

### Zeichnungen

Ausführungsbeispiele der Erfindung werden anhand der Zeichnungen und der nachfolgenden Beschreibung näher erläutert. Es zeigen beispielhaft und schematisch:
Figur 1 ein erfindungsgemäßes Bildaufnahmesystem,
Figur 2 eine Ausführungsform eines erfindungsgemäßen Spritzgießwerkzeugs,
Figur 3 das Spritzgießwerkzeug aus Figur 2 im geschlossenen Zustand, und

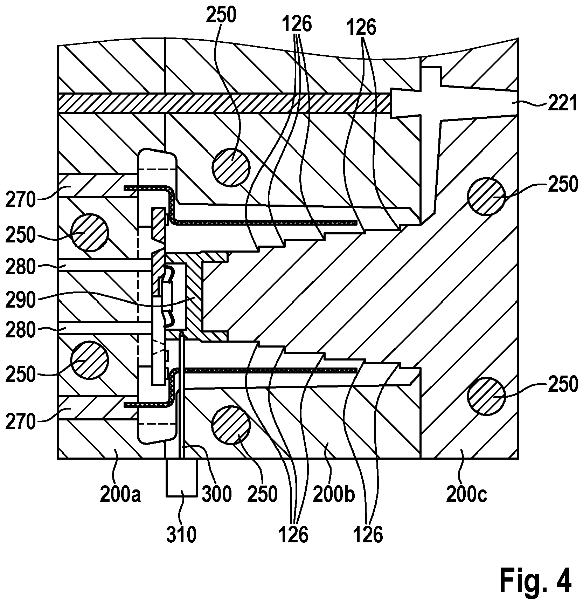

Figur 4 ein Detail des in Figur 3 gezeigten Spritzgießwerkzeugs im geschlossenen Zustand.

### Ausführungsformen der Erfindung

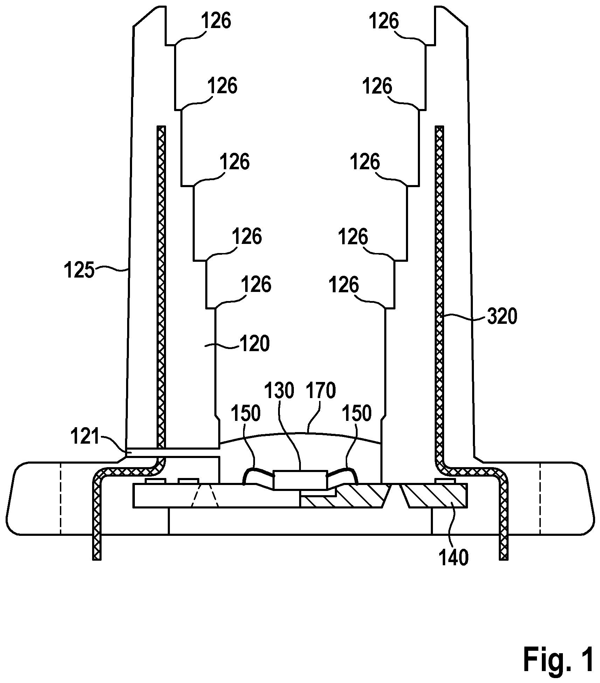

Figur 1 zeigt ein erfindungsgemäßes Bildaufnahmesystem 100. Das Bildaufnahmesystem 100 umfasst einen Optikhalter 120 und einen Bildaufnehmer 130, beispielsweise ein CCD- oder ein CMOS-Chip (Charge Coupled Device beziehungsweise Complementary Metal Oxide Semiconductor). Der Optikhalter 120 umschließt (spritzumgossen) ein Durchgangsloch, das an einem Ende von einer Oberfläche einer Trägerplatte 140 verschlossen ist, wobei auf der Oberfläche ein Bildaufnehmer 130 angeordnet ist. Ein Metallgewebe 320 ist in den Optikhalter 120 integriert. Parallel zu der Oberfläche erstreckt sich ein Nadelkanal 121 durch den Objekthalter 120 bis zu dessen Außenseite 125. Der Nadelkanal 121 ist zum Spritzgießen einer als optische Linse wirkenden Verkapselung 170 des Bildaufnehmers geeignet. Der Optikhalter 120 ist durch das Metallgewebe 320 soweit stabilisiert, dass eine als Objektiv wirkende Linsenanordnung direkt vom Optikhalter 120 mittels Haltepositionen 126 gehalten werden kann. Die Haltepositionen 126 sind im Ausführungsbeispiel stufenartige Verjüngungen des Durchgangslochs in Richtung der Trägerplatte 140. Alternativ kann der Optikhalter 120 Haltepositionen für einen Objektträger aufweisen, der dann die als Objektiv wirkende Linsenanordnung trägt.

Der Bildaufnehmer 130 ist durch Bonddrähte 150, die mit Vergießharz verfüllt sind, mit Leiterbahnen verbunden. Der Bildaufnehmer 130 ist auf einer Oberfläche der Trägerplatte 140 mit der formstabilen Verkapselung 170 versiegelt. Die Verkapselung 170 umfasst mindestens ein transparentes duroplastisches Material. Das duroplastische Material erstreckt sich durch den Nadelkanal 121 im Optikhalter 120 bis zu dessen Außenseite 125. Die Verkapselung 170 wirkt dabei als eine optische Linse.

Das Bildaufnahmesystem kann Zentrierungen umfassen, die dafür sorgen, dass optische Achsen der Linsen und des Bildaufnehmers in der Bildebene liegen und zusammenfallen.

Die Linsenanordnung kann dabei in der Position entlang der gemeinsamen optischen Achse von Linsen und Bildaufnehmer angeordnet werden, bei der der Bildaufnehmer im Fokus der Optik angeordnet ist.

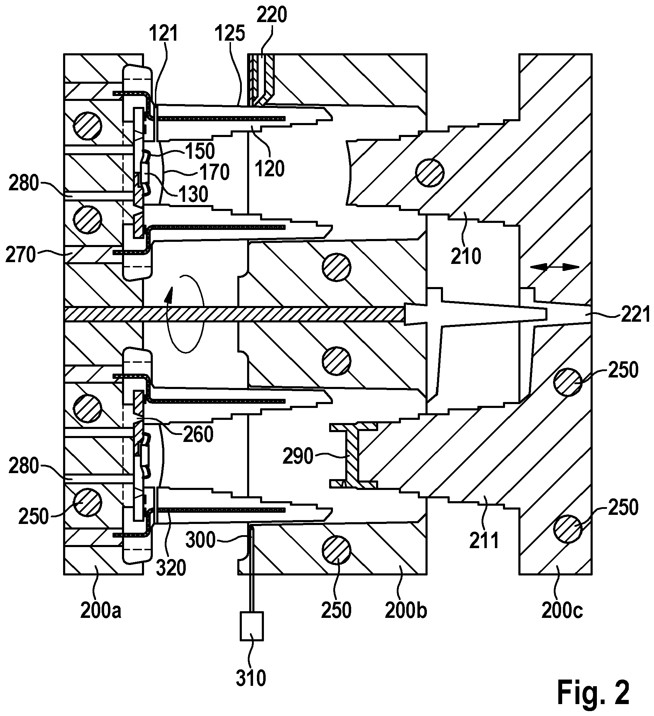

Figur 2 zeigt eine Ausführungsform des erfindungsgemäßen Spritzgießwerkzeugs 200 im geöffneten Zustand im Schnitt. Die optische Achse des Bildaufnehmers 130 liegt dabei in der Bildebene. Das Spritzgießwerkzeug 200 umfasst drei Teile 200a, 200b, 200c. Beim Zusammensetzen der Teile 200a, 200b, 200c bilden sich durch Stempel 210, 211 zwei Kavitäten, die je über einen zugehörigen Angusskanal 220, 221 mit einem duroplastischen Material gefüllt werden können. Zur Verbesserung des Spritzgießens sind Heizpatronen 250 im Spritzgießwerkzeug 200 angeordnet. Eine der Kavitäten, die durch den Stempel 211 gebildet wird, ist eine Negativform eines Optikhalters 120. Die andere der Kavitäten, die durch den Stempel 210 gebildet wird, ist eine Negativform einer verkapselnden Linse 170 zur Verkapselung des auf einer Trägerplatte 140 angeordneten Bildaufnehmers 130. Der Stempel 210 kann eine mikrostrukturierte Oberfläche aufweisen.

Das Teil 200a ist gegenüber den Teilen 200b, 200c drehbar, sodass ein auf einer Trägerplatte 140 angeordneter Bildaufnehmer 130 in der einen Kavität mit einem Optikhalter 120 umgeben werden kann, danach durch Drehung in die andere Kavität umgesetzt und dann mit einer Linse 170 verkapselt werden kann.

Dazu werden Aufnahmestifte 260 im Teil 200a in Aufnahmen in der Trägerplatte 140 eingeführt. Dann wird mit der Trägerplatte 140 die eine Kavität verschlossen und die Trägerplatte mit einem Optikhalter 120 umgeben. Optional wird ein Metallgewebe 320 in den Optikhalter 120 integriert. Eine vor dem Umgießen von einem Kernzug 310 in die Kavität einführbare Nadel 300 bewirkt dabei, dass im Optikhalter 120 ein Nadelkanal 121 verbleibt.

Durch Drehung des Teils 200a wird die Trägerplatte 140 samt umschlossenem Bildaufnehmer 130 so umgesetzt, dass die andere Kavität hiernach verschlossen werden kann. Dann wird der Hohlraum mit der Verkapselung, beispielsweise in Form einer optischen Linse, durch den von der Außenseite 125 des Optikhalters 120 zugänglichen Nadelkanal 121 im Optikhalter 120 gefüllt.

Mittels Luftkanälen 280 kann das Teil 200a von den Teilen 200b, 200c und der Trägerplatte 140 durch Druckluft gelöst werden. Ein Auswerfer 270 ermöglicht danach das Auswerfen des Bildaufnahmesystems aus der Trägerplatte 140 samt umschlossenem Bildaufnehmer 130 und Optikhalter 120.

Es ist auch möglich, dass die Trägerplatte mittels Vakuum am Teil 200a festgehalten wird, wenn Teil 200a von den Teilen 200b, 200c mittels des Auswerfers 270 getrennt wird.

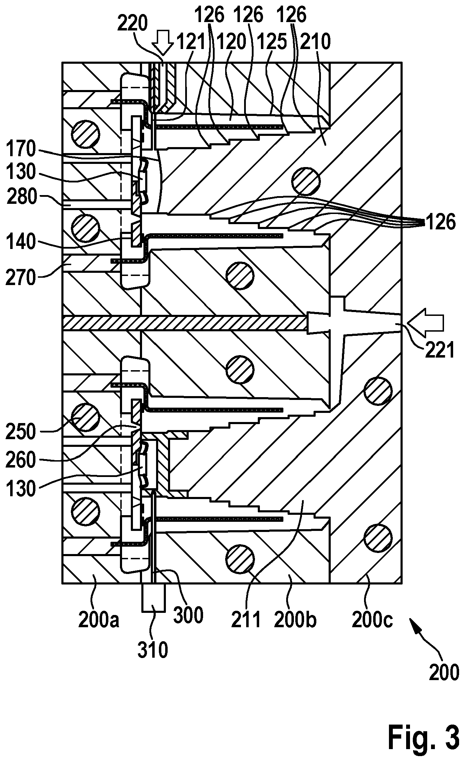

Figur 3 zeigt das Spritzgießwerkzeug aus Figur 2 im geschlossenen Zustand. Die eine Kavität wird durch die Trägerplatte 140 samt Bildaufnehmer und Stempel 211 gebildet, an dessen Ende ein Dichtkörper 290 aus zum Beispiel Perfluoralkoxy- Polymer (PFA- spritzgießbares Teflon) angeordnet ist. Durch den Kernzug 310 ist die Nadel 300 so in der Kavität angeordnet, dass sie sich bis in eine Vertiefung im Dichtkörper 290 erstreckt. Über Heizpatronen 250 lässt sich das Spritzgießwerkzeug erwärmen, sodass sich der Dichtkörper 290 ausdehnt und den Bildaufnehmer und die Bonddrähte abdichtet. Durch den Angusskanal 221 lässt sich die eine Kavität füllen, sodass ein Objekthalter 120 entsteht, wobei Bildaufnehmer und die Bonddrähte durch den Dichtkörper 290 geschützt sind. Beim Spritzgießen des Objekthalters 120 bewirkt die Nadel 300, dass ein bis zum Dichtelement 290 durchgehender Nadelkanal 121 im Objekthalter 120 offen bleibt.

Nach Umsetzen in die andere Kavität kann durch den Nadelkanal 121 die Verkapselung 170 in Form einer optischen Linse spritzgegossen werden.

Mittels Unterdruck in den Luftkanälen 280 wird die Trägerplatte 140 samt umschlossenem Bildaufnehmer 130 am Teil 200a festgehalten, wenn Teil 200a von Teil 200b mittels des Auswerfers 270 getrennt wird.

Eine weitere bespielhafte Ausführungsform der Erfindung betrifft ein Verfahren zur Herstellung von einem Bilderfassungssystem (Kamerasystem), zum Beispiel für ein Umfelderfassungssystem eines Fahrzeugs. Das Bilderfassungssystem umfasst einen Optikhalter und einen Optikträger, dessen Optik zur Führung von einfallendem Licht auf einen Bildaufnehmer dient sowie der mediendichten Implementierung der dazugehörenden Elektronik inklusive Imager-Chip.

Diese beispielhafte Ausführungsform stellt ein geeignetes Verfahren zur Verfügung, mit dem ein kostengünstiges und gegenüber Umwelteinflüssen robustes Kamerasystem hergestellt werden kann. Durch gezielte Funktionsintegration und funktionsgerechten Materialeinsatz werden weniger Prozessschritte und Einzelteile erforderlich. Zudem wird der Aufbau einfach und platzsparend, und der Kosten- und Zeitaufwand für Herstellung und Logistik wird reduziert.

Diese beispielhafte Ausführungsform ermöglicht die Herstellung von neuartigen Kameramodulen, beispielsweise für Umfelderfassungssysteme, mit einem formstabilen Gehäuse aus duroplastischen Kunststoffen und einer durch eine 2-Komponenten Verkapselung von der von dem Kamera-Bildaufnehmer gebildeten transparenten Linse. Die Fertigung kann komplett auf nur einer Spritzgießmaschine und nur in einem Spritzgießwerkzeug erfolgen. Aufgrund der geringen Viskosität der transparenten Komponente treten während des Einspritzvorgangs nur geringe Drücke auf, sodass auch Schaltungen mit Bonddraht-Schaltungen verwendet werden können, beziehungsweise auf den separaten Vergießprozess der Bonddraht-Schaltungen verzichtet werden kann. Gleichzeitig wird eine Schutzschicht ausgebildet, die die Schaltung und den Chip versiegelt und Pixelfehler durch Fernhalten von Partikeln verhindert.

Des Weiteren kann die temperaturabhängige Änderung des Brechungsindex der speziellen transparenten Vergussmasse gezielt genutzt werden, um den thermischen Fokusshift vom Objektiv zu kompensieren.

Da das transparente duroplastische Material sehr gut abgeformt wird und danach vernetzt, können in diese transparente Linse zusätzliche optische Funktionen, wie beispielsweise Entspiegelungen durch spezielle Mikrostrukturen, integriert werden.

In bestimmten Fällen kann durch die Auslegung dieser Schicht die unterste Linse im Optikträger eingespart werden.

Da das Material sehr beständig ist, hinterlassen Umwelteinflüsse, wie zum Beispiel UV Licht, auf Dauer keine Spuren in oder an der Schicht.

In einem ersten Schritt dieser Ausführungsform wird über das Handlingsystem eine mit dem Imager-Chip und der Schaltung bestückte Platine (Trägerplatte) in das geöffnete Spritzgießwerkzeug gesetzt und mit Aufnahmestiften und einem Vakuum fixiert.

Nach dem Schließen des Werkzeugs wird unter Verwendung eines Kernzugs eine Nadel in der Kavität angeordnet. Der Imager-Chip und Teile des die Leiterbahnen umgebenden Hohlraums wird durch das Schließen des Werkzeugs von einem Dichtkörper aus zum Beispiel Perfluoralkoxy- Polymer (PFAspritzgießbares Teflon) gegenüber der Kavität abgedichtet. Der Dichtkörper dehnt sich bei Temperaturerhöhung aus, wird weich und passt sich optimal an die Oberfläche der Gegenseite an, sodass keine niedrigviskose Masse durchdringen kann. Es ist empfehlenswert, den Dichtkörper nach zirka 500 Zyklen auszutauschen. In der Kavität kann anschließend ein Metallgewebe angeordnet werden und die Kavität kann mit einem wärmeleitfähigen Duroplast, wie beispielsweise Phenol-, Epoxidharz oder Bulk Molding Compounds (BMC), eventuell mit entsprechenden Füllstoffen, beispielsweise 50 bis 70% wärmeleitfähigen Feststoffpartikeln, gefüllt werden. Dabei wird der Optikhalter mit den Haltepositionen für die Linsenanordnung abgeformt, wobei die Nadel einen Nadelkanal freihält.

Es sind keine zusätzlichen Klebe-Prozessschritte für die feste Verbindung zwischen dem Halter und dem Schaltungsträger erforderlich.

Nach einer vorgegebenen Vernetzungszeit fährt der Kernzug die Nadel zurück. Dann wird der Vorspritzling ausgestoßen und durch eine Drehbewegung des auswerferseitigen Werkzeugteils über den Drehteller in eine zweite Kavität umgesetzt. Dabei wird der angesaugte Schaltungsträger samt Optikhalter durch Druckluft entformt. Alternativ kann dieser Schritt auch über das Handlingsystem erfolgen, das zum Beispiel auch am Zyklusende das fertige Bildaufnahmesystem aus Optikhalter und umschlossenem Bildaufnehmer entnimmt.

Durch die Drehbewegung ist der Nadelkanal im wieder geschlossenen Spritzgießwerkzeug vor einem Kaltkanal einer LSR-Spritzeinheit angeordnet, durch den zusammen mit dem Nadelkanal nun Imager-Chip und Teile der Leiterbahnen mit transparentem Kunststoff überspritzt werden. Dabei kann die transparente Komponente beispielsweise ein Flüssigsilikon oder eine transparente Vergussmasse auf Polyurethan- oder Epoxidbasis sein. Das Material kann zum Beispiel ein Silopren LSR 7090 von der Fa. Momentive sein. Damit die niedrigviskose Masse nicht ins Spritzgießwerkzeug läuft und die Platine optimal anliegt, kann ein Abdichtrahmen aus zum Beispiel Perfluoralkoxy-Polymer (PFA- spritzgießbares Teflon) auf der Auswerferseite fixiert sein.

Der die Linsenkavität mitausbildende Stempel kann durch Wechseleinsätze wahlweise konkav, konvex oder planparallel ausgeführt werden. Zur Entspiegelung der Linsenoberfläche kann der Werkzeugeinsatz eine Mikrostrukturierung aufweisen, welche durch den niedrigviskosen Kunststoff optimal abgeformt wird. Das Spritzgießwerkzeug kann vorteilhafterweise, beispielsweise mit elektrischen Heizpatronen, auf 120 °C bis 160 °C aufgeheizt werden, sodass die transparente Komponente vernetzt. Um eine bessere Haftung der Linse auf dem Schaltungsträger zu erhalten, können auf der Platinenrückseite einzelne Nuten für einen Formschluss eingebracht sein.

Eine Linsenanordnung kann anschließend direkt oder mittels eines Optikträgers eingeklebt werden.

Neben dem Einsatz von günstigen Werkstoffen können durch die Funktionsintegration von Formgebung und optischen Eigenschaften Arbeits- und Anlagenkosten sowie Herstellungskosten und Logistikzeit eingespart werden.

Für die Verkapselung gemäß dieser Ausführungsform werden ein 2-Komponenten-Spritzgießwerkzeug sowie eine 2-Komponenten-Spritzgießmaschine benötigt. Die Spritzgießmaschine muss mit einem Duroplast- und einem Elastomeraggregat sowie einem Drehteller und einem Handlingsystem ausgerüstet sein.

Zur Entwärmung des Imager-Chips kann ein wärmeleitfähiges duroplastisches Material eingesetzt werden. Dieses kann sowohl ein Phenolformaldehyd Compound (PF) als auch ein Epoxid (EP) oder ein Bulk Molding Compound (BMC) sein, dass mit 50 bis 70 % wärmeleitfähigen Feststoffpartikeln, wie zum Beispiel Bornitrid, Aluminium- oder Magnesiumhydroxid oder einer Kombination dieser, statt mit dem Standardfüllstoff gefüllt ist. 10 bis 30 % der Standard-Glasfasern können zusätzlich durch wärmeleitende Metallfasern aus zum Beispiel Kupfer, Aluminium, Silber oder einer Kombination dieser entsprechend der notwendigen Festigkeit des Gehäuses, substituiert werden. Die Metallfasern können ein Gewebe bilden.

Diese Metallfasern können zusätzlich für einen EMV-Schutz (Elektromagnetische Verträglichkeit) sorgen.

Aufgrund der gleichen Vernetzungstemperaturen können beide Komponenten parallel in dem Spritzgießwerkzeug mit zwei Kavitäten hergestellt werden.

Nach einer vorgegebenen Vernetzungszeit kann der komplette Optikhalter mit dem Handling aus dem Werkzeug entnommen und in einer separaten Montagelinie mit dem Optikträger durch eine Verklebung bestückt werden.

## Patentansprüche

1. Bildaufnahmesystem (100), wobei das Bildaufnahmesystem (100) zumindest einen Optikhalter (120) mit einem Durchgangsloch, eine das Durchgangsloch auf einer Seite mit einer Oberfläche verschließenden Trägerplatte (140) und einen Bildaufnehmer (130), der auf der Oberfläche der Trägerplatte (140) angeordnet ist, und einen bis vom Durchgangsloch zu einer Außenseite (125) des Optikhalters (120) durch den Optikhalter (120) durchgehenden Nadelkanal (121) umfasst, wobei der Nadelkanal (121) zum Spritzgießen einer als optische Linse wirkenden Verkapselung (170) des Bildaufnehmers geeignet ist, weiterhin umfassend die als optische Linse wirkende Verkapselung (170) des Bildaufnehmers, wobei die Verkapselung (170) mindestens ein transparentes duroplastisches Material umfasst, wobei sich das duroplastische Material durch den Nadelkanal (121) bis zu der Außenseite (125) erstreckt.

2. Bildaufnahmesystem (100) nach Anspruch 1, wobei die Trägerplatte (140) weiterhin mit einer Schaltung bestückt ist, die auch von der Verkapselung (170) umschlossen ist.

3. Bildaufnahmesystem (100) nach einem der Ansprüche 1 und 2 wobei das duroplastische Material Silikon, Polyurethan und/oder Epoxid umfasst.

4. Bildaufnahmesystem (100) nach einem der Ansprüche 1 bis 3, wobei die Verkapselung (170) eine spezielle Mikrostruktur aufweist, die entspiegelnd wirkt.

5. Bildaufnahmesystem (100) nach einem der vorangehenden Ansprüche, wobei die Trägerplatte (140) mindestens eine Bonddraht-Schaltung (150) umfasst.

6. Bildaufnahmesystem (100) nach einem der vorangehenden Ansprüche, wobei sich der Nadelkanal parallel zu der Oberfläche der Trägerplatte (140) erstreckt.

7. Bildaufnahmesystem (100) nach einem der vorangehenden Ansprüche, wobei der Optikhalter (120) ein weiteres duroplastische Material umfasst, welches ein Phenolformaldehyd Compound, ein Epoxid und/oder ein Bulk Moulding Compound umfasst, dass zu 50 bis 70% mit wärmeleitfähigen Partikeln, vorzugsweise umfassend Bornitrid, Aluminiumhydroxid und/oder Magnesiumhydroxid, versetzt ist, und/oder wobei ein Faseranteil des weiteren duroplastischen Materials zu 10 bis 30% von einem Metallgewebe (320) gebildet wird, das vorzugsweise Kuper, Aluminium und/oder Silber umfasst.

8. Bildaufnahmesystem (100) nach einem der vorangehenden Ansprüche weiterhin umfassend ein Objektiv bildende Linsen, die vom Optikhalter (120) an Haltepositionen (126) gehalten werden.

9. Kraftfahrzeug mit einem Bildaufnahmesystem (100) nach einem der vorangehenden Ansprüche.

## Claims

1. Image recording system (100), wherein the image recording system (100) comprises at least one optics holder (120) with a through-hole, a carrier plate (140) closing the through-hole with a surface on one side, and an image recorder (130), which is arranged on the surface of the carrier plate (140), and a needle channel (121) passing through the optics holder (120) to from the through-hole to an outer side (125) of the optics holder (120), wherein the needle channel (121) is suitable for injection moulding an encapsulation (170) of the image recorder acting as an optical lens, also comprising the encapsulation (170) of the image recorder acting as an optical lens, wherein the encapsulation (170) comprises at least one transparent thermosetting material, wherein the thermosetting material extends through the needle channel (121) to the outer side (125) .

2. Image recording system (100) according to Claim 1, wherein the carrier plate (140) is also provided with a circuit that is also enclosed by the encapsulation (170) .

3. Image recording system (100) according to either of Claims 1 and 2, wherein the thermosetting material comprises silicone, polyurethane and/or epoxy resin.

4. Image recording system (100) according to one of Claims 1 to 3, wherein the encapsulation (170) has a special microstructure, with an antireflective effect.

5. Image recording system (100) according to one of the preceding claims, wherein the carrier plate (140) comprises at least one bonding wire circuit (150).

6. Image recording system (100) according to one of the preceding claims, wherein the needle channel extends parallel to the surface of the carrier plate (140).

7. Image recording system (100) according to one of the preceding claims, wherein the optics holder (120) comprises a further thermosetting material, which comprises a phenol formaldehyde compound, an epoxy resin and/or a bulk moulding compound, which in a proportion of 50 to 70% is admixed with heat-conductive particles, preferably comprising boron nitride, aluminium hydroxide and/or magnesium hydroxide, and/or wherein a fibre fraction of the further thermosetting material is formed in a proportion of 10 to 30% by a metal fabric (320), which preferably comprises copper, aluminium and/or silver.

8. Image recording system (100) according to one of the preceding claims, further comprising lenses that form an objective and are held by the optics holder (120) at holding positions (126).

9. Motor vehicle with an image recording system (100) according to one of the preceding claims.

## Revendications

1. Système de prise de vues (100), le système de prise de vues (100) comprenant au moins une monture optique (120) avec un trou de passage, une plaque de support (140) fermant le trou de passage d'un côté avec une surface et un capteur d'images (130), lequel est agencé sur la surface de la plaque de support (140), et un canal d'aiguille (121) passant au travers de la monture optique (120) jusqu'à depuis le trou de passage jusqu'à une face externe (125) de la monture optique (120), dans lequel le canal d'aiguille (121) est adapté au moulage par injection d'une encapsulation (170) du capteur d'images opérant comme lentille optique, comprenant en outre l'encapsulation (170) du capteur d'images opérant comme lentille optique, dans lequel l'encapsulation (170) comprend au moins un matériau transparent thermodurcissable, dans lequel le matériau thermodurcissable s'étend à travers le canal d'aiguille (121) jusqu'à la face externe (125).

2. Système de prise de vues (100) selon la revendication 1, dans lequel la plaque de support (140) est en outre équipée d'un circuit, lequel est également enrobé par l'encapsulation (170).

3. Système de prise de vues (100) selon l'une des revendications 1 et 2, dans lequel le matériau thermodurcissable comprend du silicone, du polyuréthane et/ou de l'époxyde.

4. Système de prise de vues (100) selon l'une des revendications 1 à 3, dans lequel l'encapsulation (170) comporte une microstructure spéciale éliminant les reflets.

5. Système de prise de vues (100) selon l'une des revendications précédentes, dans lequel la plaque de support (140) comprend au moins un circuit-fil de connexion (150).

6. Système de prise de vues (100) selon l'une des revendications précédentes, dans lequel le canal d'aiguille est parallèle à la surface de la plaque de support (140).

7. Système de prise de vues (100) selon l'une des revendications précédentes, dans lequel la monture optique (120) comprend un matériau thermodurcissable supplémentaire, lequel inclut un composé phénol-formaldéhyde, un époxyde et/ou un composé de moulage en vrac (Bulk Moulding Compound-BMC), auquel sont mélangés de 50 à 70 % de particules conductrices de chaleur, contenant de préférence du nitrure de bore, de l'hydroxyde d'aluminium et/ou de l'hydroxyde de magnésium, et/ou dans lequel une fraction de fibre du matériau thermodurcissable supplémentaire est formée par 10 à 30 % d'un tissu métallique (320), lequel comprend de préférence du cuivre, de l'aluminium et/ou de l'argent.

8. Système de prise de vues (100) selon l'une des revendications précédentes comprenant en outre des lentilles formant un objectif, lesquelles sont maintenues par la monture optique (120) à des positions de maintien (126).

9. Véhicule motorisé doté d'un système de prise de vues (100) selon l'une des revendications précédentes.
